# EUROPEAN PATENT APPLICATION

(11) **EP 4 503 150 A1**
(43) Date of publication of application: **05.02.2025**
(21) Application number: 23780092.5
(22) Date of filing: 23.03.2023
(51) Int. Cl.: H01L 33/30, H01L 21/3065

(54) **METHOD FOR PRODUCING LIGHT-EMITTING ELEMENTS**

(30) Priority: 30.03.2022 JP 2022057333
(71) Applicant: Shin-Etsu Handotai Co., Ltd., Tokyo 100-0004 (JP)
(72) Inventor: ISHIZAKI, Junya, Annaka-shi, Gunma 379-0196 (JP)
(74) Representative: Sonnenhauser, Thomas Martin
(86) International application number: PCT/JP2023/011641
(87) International publication number: WO 2023/190082

(57) **Abstract**

The present invention is a method for producing a light emitting device, the method includes the steps of growing an epitaxial layer including at least a light emitting layer having (AlₓGa₁₋ₓ)_{y}In_{1-y}P (0 ≤ x < 1, 0.4 ≤ y ≤0.6) as an active layer above a starting substrate, and forming an isolation groove to form a device in the light emitting layer by an ICP dry etching method using inductively coupled plasma, in which a temperature of a substrate including the epitaxial layer at the time of processing to form the isolation groove by the ICP dry etching method is 40°C or less. Thereby, the method for producing a light emitting device can be provided, in which luminance decrease can be prevented when the light emitting device having a micro-LED size is formed by processing the epitaxial layer having the AlGaInP-based light emitting layer using the ICP dry etching method.

## Description

### TECHNICAL FIELD

The present invention relates to a method for producing a light emitting device, in particular, a method for producing an AlGaInP-based micro light emitting diode (micro LED).

### BACKGROUND ART

A technique for separating only an epitaxial function layer from a starting substrate and transferring the layer to another substrate is an important technique for mitigating restriction due to the physical properties of the starting substrates and increasing the degree of freedom in designing device systems.

By designing, for the transferring, a bonding material which can be separated in the later step as a bonding material to a different substrate, a device can be further transferred to another substrate after forming the device.

In a method for producing LEDs using an AlGaInP-based epitaxial substrate, the starting substrate is a light-absorbing substrate; and therefore, the removal of the starting substrate and transfer of the epitaxial layer, which are processes for achieving high brightness, are indispensable techniques.

There are variety of options for a transfer-destination substrate, a bonding material to the transfer-destination substrate, and a bonding method to the substrate which are used for the transferring. Depending on the techniques used, the transfer-destination substrate, the bonding material, and the bonding method suitable for transferring micro LEDs, which are micro light emitting diodes, can be selected.

For example, in the case of a GaN-based epitaxial substrate using a transparent substrate as the starting substrate, a technique, in which micro-LED devices are adhered to a donor substrate having a patterned convex-shaped silicone adhesive on a surface and then the devices is irradiated with a laser from a back surface side of the starting substrate so that the LED devices are isolated from the starting substrate and thereafter the micro-LED devices are transferred from the donor substrate to a mounting substrate, is an excellent technique which increases degree of freedom in mounting the micro-LEDs and reduces mounting cost.

However, the above-described mounting method is a method of irradiating an interface between the starting substrate and an epitaxial layer with a laser to melt the interface, thereby delaminating the epitaxial layer from the starting substrate; therefore, a material and structure design is necessary where the starting substrate is transparent to the laser light and the laser light is light-absorbed at only a to-be-melted layer. Consequently, even though the method is optimum for a GaN-based epitaxial layer having sapphire as the starting substrate, but unable to apply to an AlGaInP-based epitaxial layer having GaAs, which is not transparent for the laser light, as the starting substrate. Therefore, the same process for the GaN-based epitaxial layer cannot be applied to the AlGaInP-based epitaxial substrate having GaAs as the starting substrate.

In order to apply the above-described process, which is suitable for the GaN-based epitaxial layer, to the AlGaInP-based epitaxial layer, it is necessary to transfer the AlGaInP-based epitaxial layer onto a laser-transparent substrate and realize a structure in which a laser-absorbing layer is provided between the AlGaInP-based epitaxial layer and the laser-transparent substrate.

Patent Document 1 discloses a technique to perform thermocompression-bonding of a semiconductor epitaxial substrate to a temporary supporting substrate via a dielectric layer and a technique to separate a starting substrate from an epitaxial function layer by wet etching. In these techniques, by designing the temporary supporting substrate as a laser-transparent substrate and by designing the dielectric layer as a laser-absorbing layer, the same transfer with the above transfer suitable for the GaN-based epitaxial layer can be realized.

Although the same transfer with the transfer suitable for the GaN-based epitaxial layer can be realized by using the techniques in Patent Document 1 described above, a new problem has arisen with the micro-LED due to miniaturization.

As shown in Non Patent Document 1, a more significant luminance decrease accompanied by miniaturization is shown due to a defect formed on sides of a device or interface and surface levels during device shape-forming processing in a GaN-based light emitting device structure.

In Non-Patent Document 1, a condition for dry etching processing of the GaN-based epitaxial layer is disclosed, but a condition for an AlGaInP-based epitaxial layer is not disclosed.

In addition, Patent Document 2 discloses a technique applying ICP dry etching to a light-emitting portion including an AlGaInP-based active layer to profile the light-emitting portion; however, a technique for a dry etching condition is not disclosed.

Moreover, Patent Document 3 discloses a technique to use a mixed gas of gases such as Cl₂, and Ar for dry etching to an AlGaInP-based laser device. Patent Document 3 discloses to perform the first dry etching and the second dry etching. Although Patent Document 3 discloses that a mixing ratio of Ar gas relative to the total gas supply amount of gas in the second dry etching condition is lower than a mixing ratio of Ar gas relative to the total gas supply amount of gas in the first dry etching condition, other conditions by the mixed gas of Cl₂ and Ar are not disclosed.

Although Patent Document 4 discloses a method for producing an electronic device provided with an LED chip, a dry etching condition for forming the LED chip is not disclosed.

Patent Document 5 discloses a light emitting apparatus provided with a light emitting device. However, Patent Document 5 does not refer to etching processing to form the light emitting device.

Patent Document 6 discloses a light emitting device and a light emitting apparatus using the device. However, Patent Document 6 does not refer to etching processing to form a light emitting device.

In the prior art, no technique for a processing condition that does not cause or suppress luminance decrease due to miniaturization in ICP etching processing used to form a micro-LED having an AlGaInP-based light emitting device structure has been disclosed.

### CITATION LIST

### PATENT LITERATURE

Patent Document 1: JP 2021-27301 A
Patent Document 2: JP 2017-50406 A
Patent Document 3: JP 2014-103161 A
Patent Document 4: JP 2022-13195 A
Patent Document 5: JP 2021-36623 A
Patent Document 6: JP 2017-34231 A

### NON PATENT LITERATURE

Non Patent Document 1: JOURNAL OF VACUUM SCIENCE & TECHNOLOGY A-VACUUM SURFACES AND FILMS, Vol.20, No.5, (2002), 1566-1573

### SUMMARY OF INVENTION

### TECHNICAL PROBLEM

Conventionally, when an epitaxial layer having an AlGaInP-based light emitting layer is processed by an ICP dry etching method and a light emitting device having a micro-LED size is formed, the light emitting device formed has a problem of decreasing luminance.

The present invention has been made to solve the above-described problem. An object of the present invention is to provide a method for producing a light emitting device capable of preventing luminance decrease, when an epitaxial layer having an AlGaInP-based light emitting layer is processed by an ICP dry etching method and a light emitting device having a micro-LED size is formed.

### SOLUTION TO PROBLEM

To solve the above-described problem, the present invention provides a method for producing a light emitting device, the method comprising the steps of:
growing an epitaxial layer including at least a light emitting layer having (AlₓGa₁₋ₓ)_{y}In_{1-y}P (0 ≤ x < 1, 0.4 ≤ y ≤ 0.6) as an active layer above a starting substrate; and
forming an isolation groove to form a device in the light emitting layer by an ICP dry etching method using inductively coupled plasma,
wherein a temperature of a substrate including the epitaxial layer at the time of processing to form the isolation groove by the ICP dry etching method is 40°C or less.

By making the temperature of the substrate including the epitaxial layer 40°C or less at the time of processing to form the isolation groove by the ICP dry etching method in this way, the temperature hardly reaches dissociation temperature of P even when the temperature is elevated on the processed surface; thus, a defect is less likely to be generated on the processed surface, and luminance decrease of the light emitting device can be prevented. As a result, the luminance of the produced light emitting device is improved.

One side of the device formed by the ICP dry etching method is preferably 100 um or less.

In the case of a micro-LED having one side of the device formed by the ICP dry etching method being 100 um or less, an effect of a surface condition is larger; thus, the luminance is further improved.

It is preferred that a reaction gas used for the ICP dry etching method is a gas containing Cl₂ and Ar, or a Cl₂ gas, and
a flow rate of the Cl₂ gas is higher than a flow rate of the Ar gas, and the isolation groove is formed under a condition that a peak-to-peak voltage Vpp is 800 V or more.

Under such a condition, the time for the ICP dry etching can be reduced.

In this case, it is more preferred that the flow rate of the Ar gas of the reaction gas is 0 sccm or more and one-third or less of the flow rate of the Cl₂ gas.

Under such a condition, the time for the ICP dry etching can be reliably reduced.

### ADVANTAGEOUS EFFECTS OF INVENTION

As described above, according to the inventive method for producing a light emitting device, the luminance decrease of the produced light emitting device can be prevented. As a result, the luminance of the produced light emitting device can be improved.

### BRIEF DESCRIPTION OF DRAWINGS

FIG. 1 is a schematic cross-sectional view illustrating a step of an example of a method for producing a light emitting device according to the present invention.
FIG. 2 is a schematic cross-sectional view illustrating a step of an example of a method for producing a light emitting device according to the present invention.
FIG. 3 is a schematic cross-sectional view illustrating a step of an example of a method for producing a light emitting device according to the present invention.
FIG. 4 is a schematic cross-sectional view illustrating an example of a dry etching apparatus used in an example of a method for producing a light emitting device according to the present invention.
FIG. 5 is a schematic cross-sectional view illustrating a step of an example of a method for producing a light emitting device according to the present invention.
FIG. 6 is a schematic cross-sectional view illustrating a step of an example of a method for producing a light emitting device according to the present invention.
FIG. 7 is a schematic cross-sectional view illustrating a step of an example of a method for producing a light emitting device according to the present invention.
FIG. 8 is a graph showing luminous efficiency of light emitting devices produced in Example 1 and Comparative Example 1.
FIG. 9 is a graph showing the relation between substrate temperature and luminous efficiency in Example 2 and Comparative Example 2.

### DESCRIPTION OF EMBODIMENTS

As described above, development has been required for a method for producing a light emitting device capable of preventing luminance decrease when an epitaxial layer having an AlGaInP-based light emitting layer is processed by an ICP dry etching method and a light emitting device having micro-LED size is formed.

To solve the above problem, the present inventors have earnestly studied and found that the luminance decrease of the light emitting device can be prevented by making a temperature of a substrate including the epitaxial layer 40°C or less at the time of processing for forming an isolation groove by the ICP dry etching method. This finding has led to the completion of the present invention.

That is, the present invention is a method for producing a light emitting device, the method comprising the steps of:
growing an epitaxial layer including at least a light emitting layer having (AlₓGa₁₋ₓ)_{y}In_{1-y}P (0 ≤ x < 1, 0.4 ≤ y ≤ 0.6) as an active layer above a starting substrate; and
forming an isolation groove to form a device in the light emitting layer by an ICP dry etching method using inductively coupled plasma,
wherein a temperature of a substrate including the epitaxial layer at the time of processing to form the isolation groove by the ICP dry etching method is 40°C or less.

Hereinafter, the present invention will be described in detail with reference to the drawings. However, the present invention is not limited thereto.

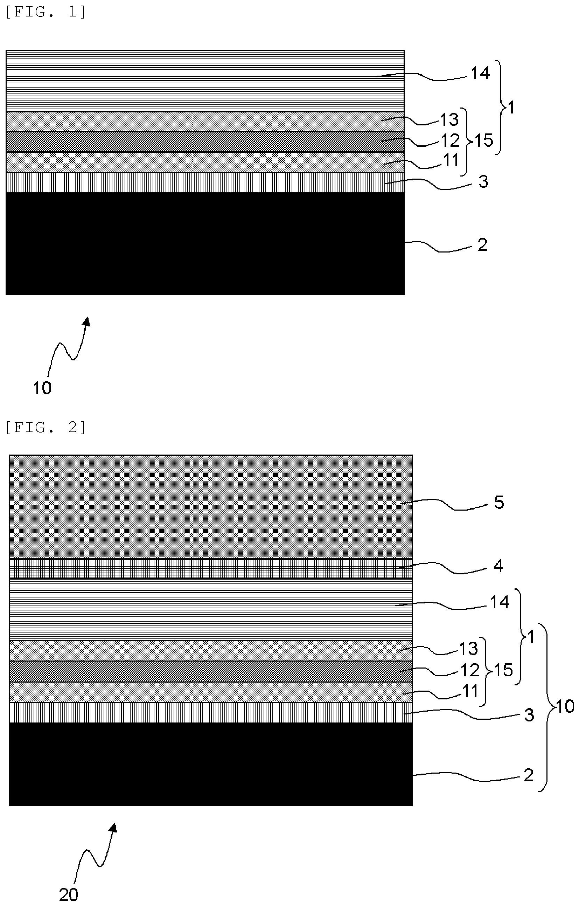

On a first conductivity-type GaAs starting substrate 2 shown in FIG. 1, a first conductivity-type GaAs buffer layer (not shown) is stacked, then a first conductivity-type GaInP first etching stop layer having a thickness of, e.g., 0.1 um and a first conductivity-type GaAs second etching stop layer having a thickness of, e.g., 0.1 um are grown to form an etching stop layer 3. Subsequently, as shown in FIG. 1, on the etching stop layer 3, a first conductivity-type AlGaInP first cladding layer (lower cladding layer) 11 having a thickness of, e.g., 1.0 um, a non-doped AlGaInP active layer 12 having a thickness of, e.g., 0.3 um, a second conductivity-type AlGaInP second cladding layer (upper cladding layer) 13 having a thickness of, e.g., 1.0 um, a second conductivity-type GaInP intermediate layer (not shown) having a thickness of, e.g., 0.1 um, and a second conductivity-type GaP window layer 14 having a thickness of, e.g., 4.0 um are sequentially grown to provide an epitaxial wafer 10 having a light emitting device structure as an epitaxial layer (epitaxial functional layer) 1. Here, the first cladding layer 11 to the second cladding layer 13 are referred to as a double-hetero (DH) structure portion (light emitting layer) 15. These series of steps are an example of a step of growing the epitaxial layer 1 including the light emitting layer 15 having (AlₓGa₁₋ₓ)_{y}In_{1-y}P (0 ≤ x < 1, 0.4 ≤ y ≤ 0.6) as the active layer 12 on the starting substrate 2.

Subsequently, as a thermosetting bonding material, for example, benzocyclobutene (BCB) is spin-coated on the epitaxial wafer 10 to form a bonding film (BCB bonding film) 4 shown in FIG. 2. Next, the epitaxial wafer 10 and a to-be-bonded wafer 5, which is, for example, a sapphire wafer, are superimposed while facing each other via a bonding film 4 and then thermocompression-bonding is performed. Thereby, an epitaxial bonded substrate 20 is produced, in which the epitaxial wafer 10 and the sapphire wafer 5 are bonded to each other via the BCB bonding film 4, as shown in FIG. 2. When BCB is applied by spin-coating, a design film thickness can be, for example, 0.6 µm.

In this embodiment, although a case where BCB is spin-coated is exemplified, a forming method of the BCB bonding film 4 is not limited to the spin-coating method as long as BCB can be uniformly formed on the epitaxial wafer 10. A dip method or other methods may be used to form the BCB bonding film 4.

Moreover, in this embodiment, a case where BCB is in a state applied in a layered shape is exemplified, but BCB is not limited to the layered shape. The same results can be obtained by pattering photosensitive BCB to an isolated island shape, a line shape or other shapes, and then performing a bonding step using the BCB bonding film thus formed.

Furthermore, in this embodiment, the thickness of the BCB bonding film 4 is set to 0.6 um, but this thickness is just an example and not limited thereto. A thickness of 0.1 um or more is preferred as sufficient bondability can be obtained. Any film thickness can be selected as the thickness of the BCB bonding film 4 but the formed BCB bonding film 4 is required to be finally removed after the formation of the light emitting device and before transferring the device to a mounting substrate. Therefore, an excessively thick BCB bonding film 4 reduces the removability of the BCB. From the viewpoint described above, a thickness of 3 um or less is more suitable, but the same effect can be obtained even with a film thickness more than that.

In addition, any condition can be selected as a bonding condition. For example, the condition can be 1.2 N/cm² or more and 200°C or more and 400°C or less.

Although the sapphire wafer is exemplified as the to-be-bonded wafer 5 in this embodiment, the to-be-bonded wafer 5 is not limited to the sapphire wafer, and any material can be selected as long as laser transparency and flatness are guaranteed. Quartz or glass may be used instead of sapphire.

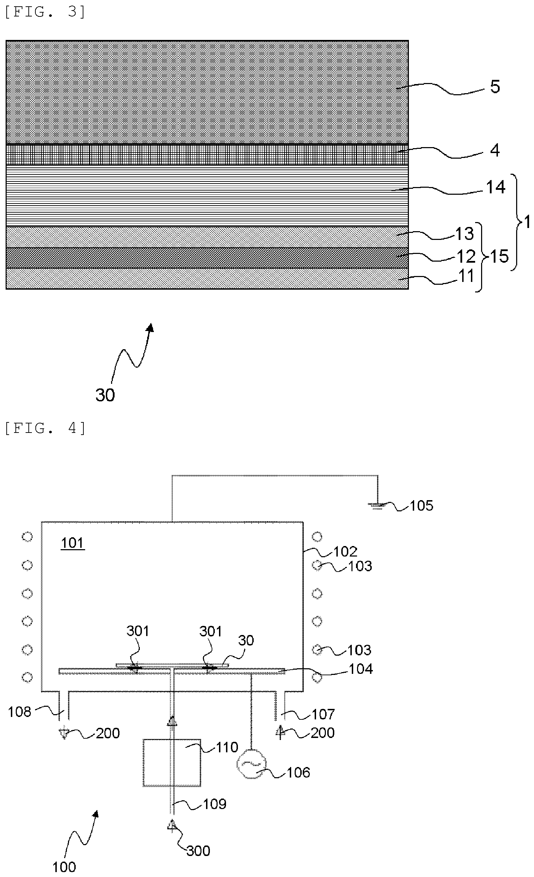

Next, the GaAs starting substrate 2 is removed by wet etching to expose the first etching stop layer; the etchant is then switched and the first etching stop layer and the second etching stop layer are removed, respectively, to expose the first cladding layer 11. Thereby, an epitaxial bonded substrate 30 is produced, in which the to-be-bonded wafer 5 holds only the light emitting layer 15 and the window layer 14 via the BCB bonding film 4, as shown in FIG. 3. This epitaxial bonded substrate 30 can be referred to as a substrate including the epitaxial layer 1.

Next, a mask pattern is formed on the epitaxial layer 1 by, for example, a photolithography method, and device isolation processing is performed by ICP (inductively coupled plasma: Inductively Coupled Plasma) dry etching. In other words, a step of forming the isolation groove to form the device in the light emitting layer 15 by the ICP dry etching method using inductively coupled plasma is performed.

A size of the device to be formed is arbitrary, but the present invention is more effective for a micro-LED having, for example, one side of 100 um or less (for example, 1 um or more and 100 um or less). The reaction gas used for ICP dry etching can be, for example, a gas containing chlorine (Cl₂) and argon (Ar), or Cl₂ gas.

In this embodiment, the ICP dry etching processing is performed twice: in a step to expose a part of the surface of the BCB bonding film 4 and in a step to expose a part of the surface of the GaP window layer 14.

A reaction gas condition during the ICP dry etching processing can be, for example, 30 to 50 sccm of Cl₂ and 0 to 20 sccm of Ar, and the processing condition where the amount of Cl₂ gas is always larger than the amount of Ar gas is suitable.

A pressure in an etching chamber for performing ICP dry etching can be, for example, 0.7 Pa.

In the present invention, the temperature of the substrate (epitaxial bonded substrate) 30 including the epitaxial layer 1 at the time of processing to form the isolation groove by the ICP dry etching method is 40°C or less. It is suitable to make the temperature of the substrate (epitaxial bonded substrate) 30 including the epitaxial layer 1 35°C or less at the time of processing to form the isolation groove by the ICP dry etching method.

Under a conventional substrate processing temperature condition (200°C), damage is prone to be inserted when a temperature of a processed surface is elevated. This is because a dissociation of P begins from 250 to 300°C under a reduced-pressure environment, and a defect is then formed on the processed surface due to P-dissociation. Even with introducing protective agents such as BCl₃ or SiCl₄ for prevention of P-dissociation, it is difficult to completely prevent P-dissociation on the processed surface. In accordance with the present invention, by virtue of making the substrate temperature 40°C or less, the temperature thereof hardly reaches the P-dissociation temperature even when the temperature is elevated on the processed surface. As a result, the defect is less prone to be generated on the processed surface. As a result, the luminance decrease of the light emitting device produced by the inventive method for producing a light emitting device can be prevented. As a result, the luminance of the light emitting device produced is improved. The lower limit of the temperature of the substrate including the epitaxial layer at the time of processing to form the isolation groove by the ICP dry etching method is not particularly limited but can be, for example, 30°C.

A specific procedure for making the temperature of the substrate (epitaxial bonded substrate) 30 including the epitaxial layer 1 40°C or less at the time of processing to form the isolation groove by the ICP dry etching method is not particularly limited but one example thereof is specifically described below referring to FIG. 4.

A dry etching apparatus 100 shown in FIG. 4 is provided with an ICP chamber 101 surrounded by a quartz wall 102. An outer periphery of the quartz wall 102 is wound with a coil 103.

A wafer fixing base and electrode 104 is provide in the ICP chamber 101. The wafer fixing base and electrode 104 can fix the epitaxial bonded substrate 30 which is a target to be processed. The fixing means is not particularly limited, but, for example, two types of methods, i.e., a mechanical fixing (chuck method) and an electrostatic fixing (electrostatic chuck) method, can be selected. In the example shown in FIG. 4, the wafer fixing base and electrode 104 is configured to fix the epitaxial bonded substrate 30 by the electrostatic chuck method.

In addition, the dry etching apparatus 100 is further provided with a bias electrode 105, an antenna power supply 106, a reaction gas inlet 107, and a reaction gas outlet 108. In the dry etching apparatus 100 having a structure shown in FIG. 4, while reaction gas 200 is introduced into the ICP chamber 101 via the reaction gas inlet 107, a plasma can be generated in the ICP chamber 101. With this plasma, the ICP dry etching processing of the epitaxial layer 1 can be performed along a mask pattern formed on the epitaxial layer 1.

In this example, during the ICP dry etching processing, He Gas 300 for keeping a constant temperature is injected from the wafer fixing base and electrode 104, being a fixed stage, to the bottom portion of the epitaxial bonded substrate 30, being the substrate to be processed.

This He Gas 300 for keeping a constant temperature is a temperature-adjusted gas. More precisely, the He Gas 300 for keeping a constant temperature is introduced from an inlet 109 for the He gas for keeping a constant temperature and passes through a temperature-adjusted chiller 110 for the He for keeping a constant temperature in which the temperature of the He gas is adjusted at a temperature of, for example, about 35°C.

The temperature-adjusted He Gas 300 for keeping a constant temperature is injected from the wafer fixing base and electrode 104 to the bottom portion of the epitaxial bonded substrate 30, being the substrate to be processed, and flows along a flow direction 301 of the He Gas for keeping a constant temperature.

By adjusting the amount of the He Gas 300 for keeping a constant temperature injected on the bottom portion of the epitaxial bonded substrate 30, the temperature at the bottom portion of the epitaxial bonded substrate 30, being the back surface of a workpiece, can be adjusted to around 35°C. The back surface temperature can be confirmed by monitoring the temperature of the wafer fixing base and electrode 104.

The entire workpiece is cooled by thermal conduction, and the thermal resistance of the sapphire substrate 5 of the epitaxial bonded substrate 30 is not zero; thus, the temperature of the back surface of the workpiece and that of the front surface do not exactly match with each other. Moreover, the temperature of the portion on the front surface of the epitaxial bonded substrate 30 that is exposed to the plasma locally becomes high. However, heat on the front surface of the epitaxial bonded substrate 30 is transmitted to the back surface side by virtue of thermal conduction and cooled as a result; and thus, the front surface of the epitaxial bonded substrate 30 can be maintained at constant temperature of 40°C or less on average. A difference in temperature between the front surface and back surface can be about 2 to 3°C.

By adjusting the temperature and flow rate of the injected He Gas 300 for keeping a constant temperature, the temperature of the substrate (epitaxial bonded substrate) 30 including the epitaxial layer 1 at the time of processing to form the isolation groove by the ICP dry etching method can be adjusted.

In the IPC dry etching processing, peak-to-peak voltage Vpp is desirably set at 800 V or more, and 1000 V or more is more suitable. By setting the peak-to-peak voltage Vpp to 800 V or more, a high etching rate can be achieved and the etching time can be reduced. Note that by increasing the peak-to-peak voltage Vpp, the temperature of the substrate tends to be elevated; however, in the inventive method for producing a light emitting device, by making the temperature of the substrate 30 including the epitaxial layer 1 40°C or less at the time of processing by the ICP dry etching method, the generation of the defects on the processed surface can be suppressed as described earlier. In the IPC dry etching processing, the peak-to-peak voltage Vpp can be, for example, 1400 V or less.

In addition, an amount of the reaction gas 200 is not limited in the flow rate range described earlier, for the amount is increased or decreased depending on the size of the ICP chamber 101 and an area to be processed on the epitaxial bonded substrate 30. The ratio, not the absolute value of the flow rate, is important, and a flow rate of Cl₂ being always more than an Ar flow rate is a suitable condition in view of the ICP dry etching rate.

Moreover, it is possible that the reaction gas 200 used for the ICP dry etching method is either gas only containing Cl₂ and Ar or Cl₂ gas only, and gases for protecting sides of the processed surface, such as SiCl₄ or BCl₃, is not introduced so that the processing is performed in an atmosphere where Cl₂, being the reaction gas, is always abundant. Ar gas is introduced for plasma stabilization, thus once the plasma is ignited and the condition of the treated workpiece is stabilized, the treatment can be performed without problems even when the introduction is stopped (Ar = 0 sccm). Ar is a suitable gas species compared to other sputtering gases as the plasma is easily stabilized.

By setting the flow rate of the Ar gas in the reaction gas 200 to 0 sccm or more and one-third or less of the flow rate of the Cl₂ gas, the ICP dry etching rate can be reliably shortened.

Although the atmosphere having 0.7 Pa is exemplified, any conditions can be selected as long as the plasma is stably generated. However, too high a pressure is not desirable, as increasing the pressure reduces the stability of the Cl₂ plasma. Moreover, when the pressure is too low, the reactive species are reduced, and the processing rate is decreased; thus, too low pressure is not preferred. It is suitable to perform processing in the range of 0.05 to 5 Pa, more preferably in the range of 0.1 to 2 Pa.

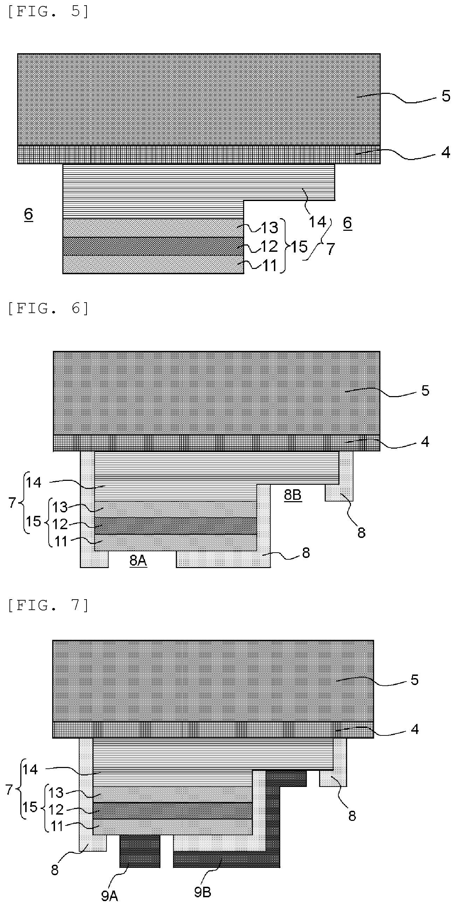

By processing using the ICP dry etching method, a light emitting device 7 can be obtained, which is isolated from other devices by an isolation groove 6 and formed, as shown in FIG. 5. The light emitting device 7 shown in FIG. 5 includes the GaP window layer 14 having a partially exposed surface and the DH structure portion 15 located thereon. The light emitting device 7 is bonded to the to-be-bonded wafer 5 via the BCB bonding film 4.

In this embodiment, a case where a part of the surface of the GaP window layer 14 is exposed is exemplified; however, it is not limited to the case where the GaP window layer 14 is exposed. It is only required that the active layer 12 is isolated from other devices at least. For example, the same effect can be obtained in a case where a part of the surface of the second cladding layer 13 is exposed instead of the exposure of a part of the surface of the GaP window layer 14.

Next, after device isolation processing as shown in FIG. 5, a protective film 8 is formed on the surface of the light emitting device 7 as an end face treatment as shown in FIG. 6. A material of the protective film 8 can be, for example, SiO₂, but it is not limited to SiO₂, and any material that can protect the end face of the light emitting device 7 and has an insulating property can be selected. SiNₓ, titanium oxide, magnesium oxide, etc., can be selected. The protective film 8 is provided with openings 8A and 8B for the formation of electrodes described later.

Next, after forming the protective film 8 as shown in FIG. 6, as shown in FIG. 7, the electrodes are formed in contact with each of the first conductivity-type layer and the second conductivity-type layer and ohmic contacts are formed by performing heat treatment. For example, in the case where the first conductivity-type is set as n-type and the second conductivity-type is set as p-type, a metal containing Au and Si can be used for a material of the electrode 9A in contact with the n-type layer (the first cladding layer 11 in FIG. 7) and a metal containing Au and Be can be used for a material of the electrode 9B in contact with P-type layer (the window layer 14 in FIG. 7). Note that the material of the n-type electrode is not limited to Au and Si, but the same result can be obtained by using, for example, metals containing Au and Ge. In addition, the material of the p-type electrode is also not limited to Au and Be, but the same result can be obtained by using, for example, metals containing Au and Zn.

By virtue of one example of the inventive method for producing a light emitting device described above, the light emitting device 7 which is provided with the electrodes 9A and 9B and bonded to the to-be-bonded wafer 5 via the BCB bonding film 4 can be obtained. In the produced light emitting device 7, the generation of the defect caused by the ICP dry etching that forms the isolation groove for the device isolation is suppressed; therefore, it is possible to suppress the luminance decrease even in a case where the device size is small, for example, in a case where one side of the device is 100 um or less, and thus the light emitting device 7 can exhibit high luminous efficiency.

The example of processing the isolation groove 6 by the ICP dry etching method on the epitaxial bonded substrate 30 is shown hereinbefore. However, in the inventive method for producing a light emitting device, the substrate to be processed by the ICP dry etching method is not limited to the epitaxial bonded substrate 30 as long as the substrate includes the epitaxial layer 1.

### EXAMPLES

Hereinafter, the present invention will be specifically described with reference to Examples and Comparative Examples. However, the present invention is not limited thereto.

### (Example 1)

In Example 1, the light emitting device was produced, according to the example of the inventive method for producing a light emitting device described referring FIGs 1 to 7. Specific conditions, etc., were as follows.

On a first conductivity-type GaAs starting substrate 2 shown in FIG. 1, a first conductivity-type GaAs buffer layer (not shown) was stacked, then a first conductivity-type GaInP first etching stop layer having a thickness of 0.1 um and a first conductivity-type GaAs second etching stop layer having a thickness of 0.1 um were grown to form an etching stop layer 3. Subsequently, as shown in FIG. 1, on the etching stop layer 3, a first conductivity-type AlGaInP first cladding layer 11 having a thickness of 1.0 um, a non-doped AlGaInP active layer 12 having a thickness of 0.3 um, a second conductivity-type AlGaInP second cladding layer 13 having a thickness of 1.0 um, a second conductivity-type GaInP intermediate layer (not shown) having a thickness of 0.1 µm, and a second conductivity-type GaP window layer 14 having a thickness of 4.0 µm were sequentially grown to produce an epitaxial wafer 10 having a light emitting device structure as an epitaxial layer (epitaxial functional layer) 1.

Subsequently, benzocyclobutene (BCB) was spin-coated as a thermosetting bonding material on the epitaxial wafer 10 to form a bonding film 4 shown in FIG. 2. Next, the epitaxial wafer 10 and a sapphire wafer 5, being a to-be-bonded wafer, were superimposed while facing each other via the bonding film 4 and then thermocompression-bonding was performed under bonding conditions of 2 N/cm² and 250°C. Thereby, an epitaxial bonded substrate 20 was produced, in which the epitaxial wafer 10 and the sapphire wafer 5 were bonded to each other via the BCB bonding film 4 as shown in FIG. 2. When BCB was applied by spin-coating, a design film thickness was 0.6 µm.

Next, the GaAs starting substrate 2 was removed by wet etching to expose the first etching stop layer; the etchant was then switched and the first etching stop layer and the second etching stop layer were removed, respectively, to expose the first cladding layer 11 as shown in FIG. 3. Thereby, an epitaxial bonded substrate 30 shown in FIG. 3 was obtained.

Next, a mask pattern was formed on the epitaxial layer 1 by a photolithography method so as to make one side 50 um, and the epitaxial bonded substrate 30 including the epitaxial layer 1 was subjected to device isolation processing by ICP dry etching.

In the ICP dry etching, a dry etching apparatus 100 described referring to FIG. 4 was used, and chlorine (Cl₂) and argon (Ar) were used as reaction gases. The ICP dry etching processing was performed twice: in a step to expose a part of the surface of the BCB bonding film 4 and in a step to expose a part of the surface of the GaP window layer 14. Thus, a light emitting device 7 isolated by an isolation groove 6 shown in FIG. 5 was formed.

A flow rate of Cl₂ was set to 30 sccm, a flow rate of Ar was set to 10 sccm, and pressure was set to 0.7 Pa. During the ICP dry etching, a He Gas 300 for keeping a constant temperature, temperature of which was adjusted at 25°C, was injected on a bottom portion of the epitaxial bonded substrate 30 at a flow rate of 20 to 30 sccm, thereby maintaining the temperature of the epitaxial bonded substrate 30 constant at 30°C.

In addition, an antenna power and a bias power were adjusted so to make peak-to-peak voltage Vpp in a range of 1000 to 1200 V, and then the ICP dry etching processing was performed.

Next, subsequent to the device isolation processing, a protective film 8 made of SiO₂ was formed on a surface of the light emitting device 7 as end face treatment as shown in FIG. 6.

After forming the protective film 8, as shown in FIG. 7, electrodes 9A and 9B were formed in contact with the first conductivity-type layer and the second conductivity-type layer, respectively, and ohmic contacts were formed by performing heat treatment.

Specifically, the first conductivity-type was designed as n-type, the second conductivity-type was designed as p-type, and a metal containing Au and Si was used for the electrode 9A in contact with the first cladding layer 11, being an n-type layer, and a metal containing Au and Be was used for the electrode in contact with the window layer 14, being a p-type layer.

By the above procedure, the light emitting device 7, being bonded to the to-be-bonded wafer 5 via the BCB bonding film 4 and provided with the electrodes 9A and 9B, was produced, as shown in FIG. 7.

### (Comparative Example 1)

In Comparative Example 1, a light emitting device was produced in the same method as in Example 1 except that conditions for ICP dry etching were as follows: a temperature of an epitaxial bonded substrate 30 was 200°C; a reaction gas used was a mixed gas of Cl₂, SiCl₄, and Ar; respective flow rate was Cl₂ = 2.5 sccm, SiCl₄ = 1 sccm and Ar = 15 sccm; pressure in a chamber was 0.7 Pa; and peak-to-peak voltage Vpp was about 400 to 500 V.

### [Results of Example 1 and Comparative Example 1]

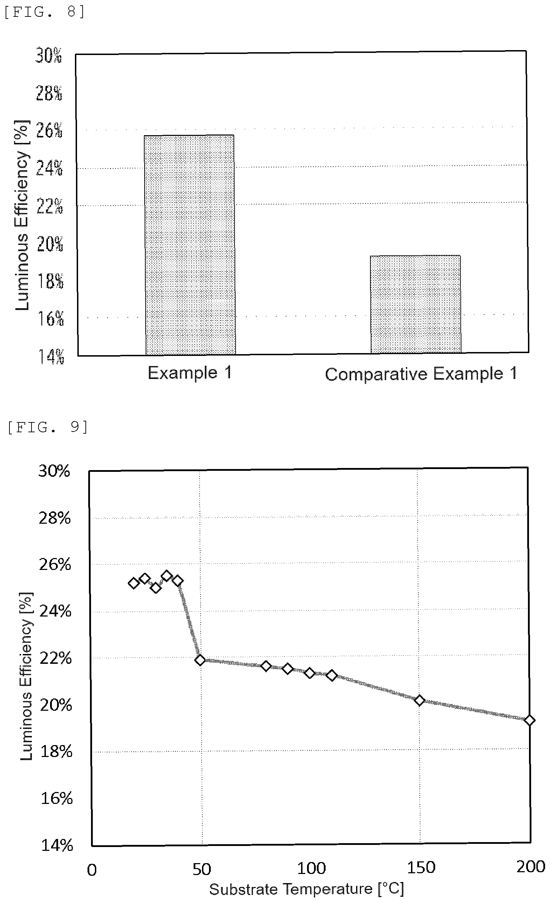

FIG. 8 shows a result of the comparison of luminous efficiency of the light emitting device 7 of a 50 um square die produced in Example 1 with a light emitting device having the same size produced in Comparative Example when a current was applied at a current density of 3.2 A/mm². From FIG. 8, it is found that the light emitting device 7 produced in Example 1 has higher luminous efficiency than the light emitting device produced in Comparative Example. This result indicates that Example 1, being an example of the present invention, was able to suppress luminance decrease, compared with Comparative Example 1.

### (Example 2)

In Example 2, light emitting devices 7 of 50 um square die were produced under the same condition as in Example 1 except that ICP dry etching was performed by: peak-to-peak voltage Vpp was constant at about 900V; a flow rate of reaction gas 200 was under the condition of Cl₂ = 30 sccm, Ar = 10 sccm; a temperature of an epitaxial bonded substrate 30, which was to be maintained constant during ICP dry etching, was varied in a range of 20°C or more and 40°C or less.

### (Comparative Example 2)

In Comparative Example 2, light emitting devices 7 of 50 um square die were produced under the same condition as in Example 2 except that ICP dry etching was performed by varying a temperature of an epitaxial bonded substrate 30, which was to be maintained constant during the ICP dry etching, in a range of more than 40°C and 200°C or less.

In Example 2 and Comparative Example 2, the temperature of the epitaxial bonded substrate 30, which was to be maintained constant during the ICP dry etching, was varied by adjusting a temperature of a He Gas 300 for keeping a constant temperature and controlling a flow rate of the thermostatic He Gas 300 for keeping a constant temperature.

### [Results of Example 2 and Comparative Example 2]

FIG. 9 shows results of investigation for luminous efficiency at a current density of 3.2 A/mm² for each light emitting device 7 produced in Example 2 and each light emitting device produced in Comparative Example 2. As shown in FIG. 9, in Comparative Example 2, where the temperature of the substrate 30 was more than 40°C and 200°C or less during ICP etching processing, external quantum efficiency (luminous efficiency) tended to increase as the temperature of the epitaxial bonded substrate 30 during the ICP etching processing was decreased, but the efficiency remained at a very low level up to about 110°C and the efficiency was still low at 50°C. On the other hand, when the temperature of the epitaxial bonded substrate 30 during the ICP etching processing was set to 40°C, a remarkable improvement tendency of the luminous efficiency was confirmed, and Example 2, where the temperature of the epitaxial bonded substrate 30 during the ICP etching processing was set to 40°C or less, showed generally satisfactory tendency.

That is, Example 2, where the temperature of the epitaxial bonded substrate 30 during the ICP etching processing was set to 40°C or less, was able to suppress the luminance decrease, compared with Comparative Example 2.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for producing a light emitting device, the method comprising the steps of:
growing an epitaxial layer including at least a light emitting layer having (AlₓGa₁₋ₓ)_{y}In_{1-y}P (0 ≤ x < 1, 0.4 ≤ y ≤ 0.6) as an active layer above a starting substrate; and
forming an isolation groove to form a device in the light emitting layer by an ICP dry etching method using inductively coupled plasma,
wherein a temperature of a substrate including the epitaxial layer at the time of processing to form the isolation groove by the ICP dry etching method is 40°C or less.

2. The method for producing a light emitting device according to claim 1,
wherein one side of the device formed by the ICP dry etching method is 100 um or less.

3. The method for producing a light emitting device according to claim 1 or 2,
wherein a reaction gas used for the ICP dry etching method is a gas containing Cl₂ and Ar, or a Cl₂ gas, and
a flow rate of the Cl₂ gas is higher than a flow rate of the Ar gas, and the isolation groove is formed under a condition that a peak-to-peak voltage Vpp is 800 V or more.

4. The method for producing a light emitting device according to claim 3,
wherein the flow rate of the Ar gas of the reaction gas is 0 sccm or more, and one-third or less of the flow rate of the Cl₂ gas.
